(19) **Europäisches Patentamt**

**European Patent Office**

**Office européen des brevets**

(11) **EP 1 502 356 B1**

(12) **EUROPEAN PATENT SPECIFICATION**

(45) Date of publication and mention
of the grant of the patent:
**22.11.2006 Bulletin 2006/47**

(51) Int Cl.:
**H03M 13/15** $^{(2006.01)}$

(21) Application number: **03732314.4**

(22) Date of filing: **06.05.2003**

(86) International application number:
**PCT/EP2003/004689**

(87) International publication number:
**WO 2003/096546 (20.11.2003 Gazette 2003/47)**

(54) **A METHOD OF SOFT-DECISION DECODING OF REED-SOLOMON CODES**

METHODE ZUR DEKODIERUNG VON REED-SOLOMON KODES MITTELS FEINENTSCHEIDUNG

PROCEDE DE DECODAGE A DECISION SOUPLE DE CODES DE REED-SOLOMON

(84) Designated Contracting States:
**DE FR GB IT**

(30) Priority: **08.05.2002 EP 02010430**

(43) Date of publication of application:
**02.02.2005 Bulletin 2005/05**

(73) Proprietor: **Thomson Licensing**
**92100 Boulogne-Billancourt (FR)**

(72) Inventors:
 • **MÜLLER, Stefan**
 **78087 Mönchweiler (DE)**
 • **KRAVTCHENKO, Alexander**
 **78056 Villingen-Schwenningen (DE)**
 • **KABUTZ, Marten**
 **78052 Villingen-Schwenningen (DE)**

(74) Representative: **Thies, Stephan**
**Deutsche Thomson-Brandt GmbH,**
**European Patent Operations,**
**Karl-Wiechert-Allee 74**
**30625 Hannover (DE)**

(56) References cited:
US-A- 4 868 828          US-A- 5 537 426
US-B1- 6 304 994         US-B1- 6 347 389

 • DONG-SUN KIM ET AL: "Implementation of high speed reed-solomon decoder" PROC. OF 42ND MIDWEST SYMPOSIUM ON CIRCUITS AND SYSTEMS, 8 August 1999 (1999-08-08), pages 808-812, XP010511073 Las Cruces, USA
 • MOON HO LEE ET AL: "A high speed Reed-Solomon decoder" PROC. OF IEEE SIGNAL PROCESSING SOCIETY WORKSHOP, SAKAI, JAPAN, 16 September 1995 (1995-09-16), pages 362-367, XP010193933 ISBN: 0-7803-2612-1

**Description**

**Field of the invention**

The present invention pertains generally to error detection/correction and more particularly to systems and methods used in Reed-Solomon decoders.

**Background and prior art**

A commonly used error correcting technique is the Reed-Solomon error correcting code. For an overview and for applications of Reed-Solomon codes reference is made to "Reed-Solomon Codes and Their Applications", Stephen B. Wicker, Vijay K. Bhargava, IEEE Press, 1994 and "Digital Communications, Fundamentals and Applications", Second Edition, Bernard Sklar, Prentice Hall PTR, 2001.

US patent no. 5,517,509 shows a Reed-Solomon decoder in the form of a Euclid's algorithm operation circuit in which division polynomials are repeatedly divided by residues resulting from the division process of dividend polynomials and division polynomials until the degree of residues of the division process satisfies a prescribed condition.

The Euclid's algorithm operation circuit comprises register groups for storing dividend polynomials and division polynomials, respectively, a feedback loop for storing residues resulting from the division process of the dividend polynomials by the division polynomials, a shifter for shifting contents of registers, and an exchanger for exchanging coefficients of the dividend polynomials with coefficients of the division polynomials.

The decoder comprises a syndrome operator for calculating syndromes from received code-words, an erasure locator generator for generating erasure locator data from erasure locator flags synchronous with received code-words, a modified syndrome generator for generating modified syndromes, an erasure locator polynomial generator for generating erasure locator polynomials from the erasure locator data, a Euclid's algorithm operation circuit for obtaining error locator polynomials and error value polynomials, a Chien searcher for obtaining error locations and error values and a correction processor for correcting errors of the received code-word. The modified syndrome generator and the erasure locator polynomial generator are used jointly with the Euclid's algorithm operation circuit.

Other approaches for implementing a Reed-Solomon decoder are know from US patent nos. 5,991,911, 6,032,283, 6,304,994 B1, 5,537,426 and EP 0 821 493 A1 and EP 0 942 421 A1. In DONG-SUN KIM ET AL: "Implementation of high speed reed-solomon decoder" PROC. OF 42ND MIDWEST SYMPOSIUM ON CIRCUITS AND SYSTEMS, 8 August 1999 (1999-08-08), pages 808-812, XP010511073, a VLSI implementation of Reed-Solomon decoder with an architecture featuring parallel and pipelined processing is described. In MOON HO LEE ET AL: "A high speed Reed-Solomon decoder" PROC. OF IEEE SIGNAL PROCESSING SOCIETY WORKSHOP, SAKAI, JAPAN, 16 September 1995 (1995-09-16), pages 362-367, XP010193933, an architecture of an error correction circuit suitable for high-rate data decoding of the Reed-Solomon Code is described. US-B1-6 304 994 (OH KYU-TAEG ET AL) 16 October 2001 (2001-10-16) describes a Reed-Solomon (RS) decoder and a decoding method therefor, where it is possible to simplify the circuit structure by minimizing the number of multipliers required for calculating the polynomial.

Usually the computation of the modified syndrome polynomial is performed by computation of the product of the syndrome and erasure polynomials. This computation requires additional cycles and computation time to obtain the modified syndrome polynomial.

It is therefore an object of the present invention to provide for a method of soft-decision decoding of Reed-Solomon codes where the calculation of the modified syndrome polynomial does not require additional cycles.

**Summary of the invention**

The object of the invention is solved basically by applying the features laid down in the independent claims. Preferred embodiments of the invention are given in the dependent claims.

The present invention enables to minimize the computation time for soft-decision decoding of Reed-Solomon codes by parallel on-the-fly computation of the syndrome and erasure polynomials as well as the modified syndrome polynomial. In other words, the invention enables to perform the calculation of the modified syndrome polynomial before the computation of the syndrome and erasure polynomials has been completed.

The present invention is particularly advantageous in that it enables to compute the modified syndrome polynomials on-the-fly with the incoming symbols. Therefore a separate computation step usually referred to as polynomial expansion can be omitted.

It is a further advantage that after correction a direct update of the modified syndromes can be performed without computation of the product of the syndrome and erasure polynomials. This results in a reduction of the overall computation time and hardware requirements.

The general idea of the invention is to reduce the number of cycles needed to compute the modified syndrome.

To obtain the modified syndrome polynomial a multiplication of the erasure and syndrome polynomial has to be done. The complexity of the conventional serial algorithm for that is

$$c = r(l+1) - l(l+1)/2,$$

where r is the number of parity symbols in a RS code word and 1 is the number of erasures in a code word. The complexity of the conventional serial-parallel algorithm is

$$c = l + 1.$$

The general idea of the invention is to compute the modified syndrome on-the-fly. Therefore the present method does not need any additional cycles for computation of the modified syndrome, which saves computation power and time.

**Brief description of the drawings**

Figure 1    shows a block diagram of a hardware implementation of a known on-the-fly syndrome computation,

Figure 2    shows a block diagram of a hardware implementation of a known on-the-fly computation of the erasure polynomial,

Figure 3    is illustrative of a flowchart of an embodiment for on-the-fly computation of the modified syndrome polynomial,

Figure 4    is a block diagram of a hardware implementation for on-the-fly computation of the modified syndrome polynomials,

Figure 5    is a timing diagram, which is related to the flowchart of Figure 3,

Figure 6    is illustrative of an alternative method for on-the-fly computation of the modified syndrome polynomials,

Figure 7    is a block diagram of a hardware implementation of the method of Figure 6,

Figure 8    is a timing diagram relating to the method of Figure 6.

**Detailed description**

In soft-decision decoding it is known that a receiver can correct as long as

$$2e + f < d_{\min} . \tag{1}$$

where e is the number of errors, f is the number of erasures, and $d_{\min}$ is the Hamming distance.
For Computing the errors the following steps have to be done:

1. Compute the syndrome polynomial

$$S(x) = \sum_{i=0}^{N-1} v_i + \sum_{i=0}^{N-1} v_i \alpha^i x + \sum_{i=0}^{N-1} v_i \alpha^{2i} x^2 + ... + \sum_{i=0}^{N-1} v_i \alpha^{(M-1)i} x^{M-1} \tag{2}$$

2. Compute the erasure polynomial, where $\alpha^{j_i}$ is the power of the positions $j_0, j_1,..., j_{p-1}$ of the erasures

$$\Gamma(x) = \prod_{i=0}^{P-1} \left(1 - \alpha^{j_i} x\right) \tag{3}$$

3. Construct the modified syndrome polynomial by

$$T(x) = \Gamma(x)S(x) \bmod x^M \tag{4}$$

4. Solve the key equation

$$\Lambda(x)\, T(x) = \Omega(x) \bmod x^M \tag{5}$$

with Berlekamp-Massey or Euclid's algorithm.

5. Compute the Forney polynomial

$$\Psi(x) = \Lambda(x)\Gamma(x) \tag{6}$$

6. Compute the magnitude of the errors and erasures using the Forney equation.

As apparent from Equations (2) and (3), they can be computed on-the-fly with the incoming data symbols $v_{N-1},...,v_1,v_0$.

In the following a more detailed explanation of an implementation of above step 1, i.e. Equation (2), is given.

Let the error vector be $\vec{e} = \left[e_0, e_1, ..., e_{N-1}\right]$ with polynomial representation

$$e(x) = e_0 + e_1 x + ... + e_{N-1} x^{N-1} \text{ with } e_i \in GF(2^8). \tag{7}$$

The received polynomial at the input of the decoder is then

$$v(x) = c(x) + e(x) = v_0 + v_1 x + ... + v_{N-1} x^{N-1} \text{ with } v_i \in GF(2^8), \tag{8}$$

where the polynomial coefficients are components of the received vector $\vec{v}$. Since the code word polynomial $c(x)$ is divisible by the generator polynomial $g(x)$, and $g(\alpha^i) = 0$ for $i=0,1,...,M-1$, evaluating the polynomial $v(x)$ at the roots of the generator polynomial, which are $\alpha^0, \alpha^1, ..., \alpha^{M-1}$ yields to

$$v(\alpha^j) = c(\alpha^j) + e(\alpha^j)$$
$$= e(\alpha^j) = \sum_{i=0}^{N-1} e_i \alpha^{ij}, \ j = 0,1,...,M-1. \tag{9}$$

That signifies that the final equation set involves only components of the error pattern not those of the code word. They are called as syndromes $S_j$, $j = 0,1,...,M-1$, where

$$S_j = v\left(\alpha^j\right) = \sum_{i=0}^{N-1} v_i \alpha^{ij}, \quad j = 0,1,...,M-1 . \tag{10}$$

These syndromes are used to form a syndrome polynomial in the form

$$S(x) = \sum_{i=0}^{N-1} v_i + \sum_{i=0}^{N-1} v_i \alpha^i x + \sum_{i=0}^{N-1} v_i \alpha^{2i} x^2 + ... + \sum_{i=0}^{N-1} v_i \alpha^{(M-1)i} x^{M-1}$$
$$= S_0 + S_1 x + S_2 x^2 + ... + S_{M-1} x^{M-1} . \tag{11}$$

An on-the-fly computation of Equation (11) can be achieved by iteratively updating the coefficients $S_i$, $i=0,1,...,$ $M$-1. At each symbol clock $j$, a new symbol $v_n$ is arriving, the power $\alpha^n$ of the position $n$ is computed and the coefficients are updated in the following way:

$$S_{i,j} = S_{i,j-1} + v_n \alpha^{in}, \quad i = 0,1,...,M-1 \text{ where } S_{i,-1} = 0 . \tag{12}$$

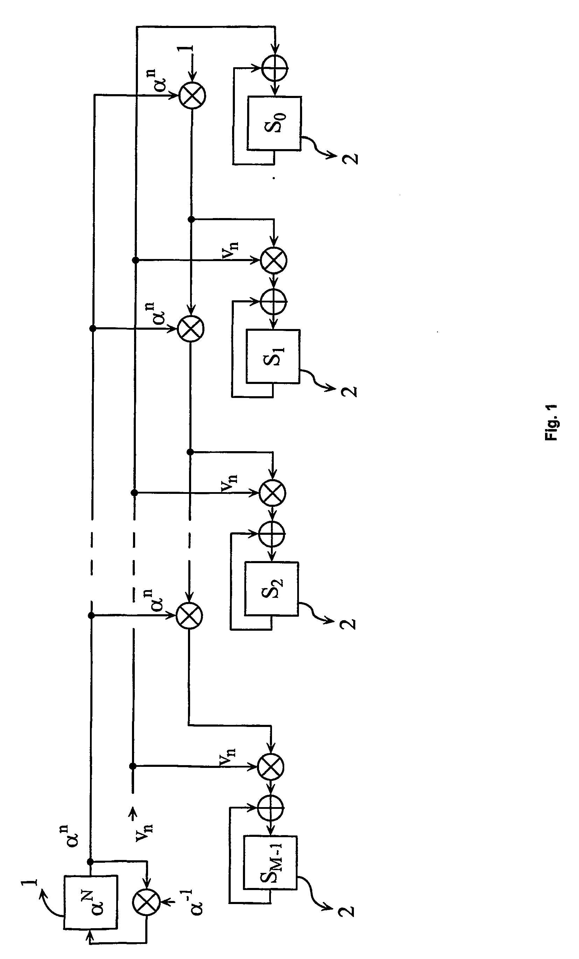

A hardware implementation of an on-the-fly syndrome computation is shown in Figure 1. At the beginning of a new code sequence, register 1 is initialised with the power of the position of the first symbol. The registers 2 are initialised with zero. Each time a new symbol arrives, register 1 and registers 2 are clocked, the syndromes are updated according to Equation (12) and the power of the root term in register 1 is decreased by one.

In the following a more detailed explanation of above step 2, i.e. Equation (3), is given.

Assuming $p$ erasures at positions $j_0, j_1,..., j_{p-1}$, the erasure polynomial is computed in the following manner

$$\Gamma(x) = \prod_{i=0}^{p-1} \left(1 - \alpha^{j_i} x\right)$$
$$= \Gamma_0 + \Gamma_1 x + \Gamma_2 x^2 + ... + \Gamma_p x^p \tag{13}$$

An on-the-fly computation of that equation can be achieved by iteratively updating the polynomial. Each time $j$, when a new erasure $v_n$ occurs, the power $\alpha^n$ of the erasure position $n$ is computed and the polynomial is updated in the following way

$$\Gamma_j(x) = \Gamma_{j-1}(x) \cdot \left(1 - \alpha^n x\right) = \left(\Gamma_{0,j-1} + \Gamma_{1,j-1} x + ... + \Gamma_{p,j-1} x^p\right)\left(1 - \alpha^n x\right) \tag{14}$$

Examining the final polynomial of Equation (14), the coefficients can be written as

$$\Gamma_{i,j} = \begin{cases} \Gamma_{i,j-1} + \alpha^n \Gamma_{i-1,j-1} & ,i = 1,2,...,p \\ 1 & ,i = 0 \end{cases} , \text{ where } \Gamma_{i,-1} = 0 . \tag{15}$$

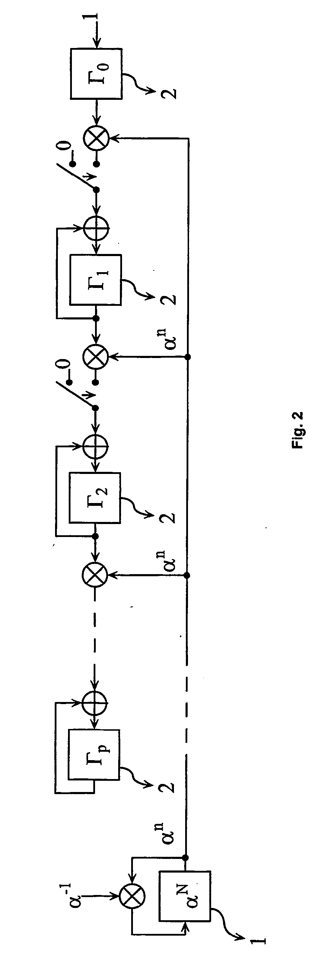

A hardware implementation of an on-the-fly erasure polynomial computation, achieved by Equation (15) is depicted in Figure 2. If the incoming symbol is an erasure, the depicted switches are toggled and the circuit realizes the computation according Equation (15).

The switches remain in their depicted position if the symbol is not an erasure. The switches are realized as combinatorial logic; hence they do not cause any extra clock delay. They are directly connected to the erasure signal provided with the symbol information. At the beginning of a new code sequence register 1 is initialised with the power of the position of the first symbol, for example with $\alpha^{181}$ for the inner code of DVD.

The registers 2 are initialised with zero. Each time, when a new symbol arrives, register 1 and registers 2 are clocked, the syndromes are then updated according to Equation (15) and the power of the root term in register 1 is decreased by one.

The modified syndrome polynomial is obtained by multiplying the syndrome polynomial of Equation (2) with the erasure polynomial of Equation (3), according to

$$T(x) = S(x)\Gamma(x)\bmod x^M$$
$$= \left(S_0 + S_1 x + S_2 x^2 + \ldots + S_{M-1}x^{M-1}\right)\left(\Gamma_0 + \Gamma_1 x + \Gamma_2 x^2 + \ldots + \Gamma_p x^p\right)\bmod x^M \qquad (16)$$

The result is a cyclic convolution between the two polynomials

$$T(x) = S_0\Gamma_0 + (S_1\Gamma_0 + S_0\Gamma_1)x + (S_2\Gamma_0 + S_1\Gamma_1 + S_0\Gamma_2)x^2 + \ldots + \sum_{j=0}^{M-1} S_j\Gamma_{M-1-j}x^{M-1} \qquad (17)$$

According to the present invention, we start by substituting Equation (2) into (17), which yields

$$T(x) = \sum_{i=0}^{N-1} v_i + \left(\sum_{i=0}^{N-1} v_i\alpha^i + \sum_{i=0}^{N-1} v_i\Gamma_1\right)x + \left(\sum_{i=0}^{N-1} v_i\alpha^{2i} + \sum_{i=0}^{N-1} v_i\alpha^i\Gamma_1 + \sum_{i=0}^{N-1} v_i\Gamma_2\right)x^2 + \ldots$$
$$+ \sum_{j=0}^{M-1}\sum_{i=0}^{N-1} v_i\alpha^{ij}\Gamma_{M-1-j}x^{M-1} \qquad (18)$$

or better

$$T(x) = \sum_{i=0}^{N-1} v_i\left(1 + \left(\alpha^i + \Gamma_1\right)x + \left(\alpha^{2i} + \alpha^i\Gamma_1 + \Gamma_2\right)x^2 + \ldots + \sum_{j=0}^{M-1}\alpha^{ij}\Gamma_{M-1-j}x^{M-1}\right). \qquad (19)$$

This equation can now be interpreted in a way that indicates how to update the polynomial coefficients taking previous erasures into account. Assuming that at the time step $j$-1 the registers $T_i, i = 0,1,\ldots M$-1 hold the correct modified syndromes and that we receive at time step $j$ a further data symbol, we simply update the modified syndrome polynomial according to Equation (19).

With that information we can write down an algorithm A for an on-the-fly computation of the modified syndromes. Depending on whether the incoming symbol is or is not signalled as an erasure, Algorithm A needs two or one consecutive computations, respectively. But it is also possible to write down an alternative algorithm B for an on-the-fly computation of the modified syndromes. Algorithm B consists of two alternative branches, one of which is selected and performed depending on whether the incoming symbol is or is not signalled as an erasure, and where each of the branches needs just one system clock for performing all the computations necessary for the case in question.

**Algorithm A**

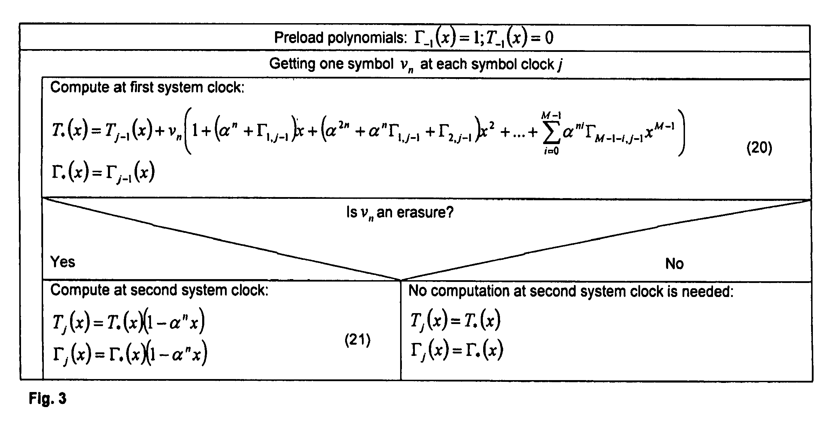

With Equation (19) it is possible to compute the modified syndrome directly without the computation of the syndromes. The flowchart in Figure 3 shows the first embodiment of an on-the-fly computation. The flowchart comprises Equation (20) to calculate two auxiliary terms $T_*(x)$, $\Gamma_*(x)$ and Equation (21) to calculate an iteration result $T_j(x)$, $\Gamma_j(x)$ from the auxiliary terms in case the incoming symbol $v_n$ is an erasure. At each symbol clock, when a new symbol is obtained, the modified syndromes are updated according to Equation (20). At every step of the calculation, the resulting modified syndromes are correct up to the latest received symbol.

For this algorithm the system clock rate has to be at least twice the symbol clock rate. The algorithm ends after the computation for the last symbol, then the correct modified syndrome is obtained.

In case of an erasure two system clocks are needed, one for the updating according to Equation (20) and one for multiplying the polynomial with the root as described by Equation (21). In case of an erasure, the order of computing Equation (20) and (21) can be interchanged. If so, it must be taken care, that if the first symbol of the stream is an erasure, the register $T_0$ must be preloaded with one, otherwise the first part of Equation (21) would yield zero.

The calculation of Equation (20) directly results from the cyclic convolution described in Equation (19). Therefore we describe in the following the algorithm of getting an erasure symbol.

Assume that up to time step $n$-1 we have in memory the following modified syndrome, which is the linear convolution of Equation (19)

$$T_{n-1}(x) = \sum_{i=0}^{n-1} v_i \left[ 1 + \left( \alpha^i + \Gamma_{1,n-1} \right)x + \left( \alpha^{2i} + \alpha^i \Gamma_{1,n-1} + \Gamma_{2,n-1} \right)x^2 + \ldots \right.$$
$$\left. \ldots + \sum_{j=0}^{M-1} \alpha^{ij} \Gamma_{M-1-j,n-1} x^{M-1} \right] \tag{22}$$

and the erasure polynomial

$$\Gamma_{n-1}(x) = 1 + \Gamma_{1,n-1}x + \Gamma_{2,n-1}x^2 + \ldots + \Gamma_{p,n-1}x^p . \tag{23}$$

Next we assume that at time step n an erasure symbol $v_n$ is coming, therefore computation of Equation (20) yields

$$T_*(x) = \sum_{i=0}^{n-1} v_i \left( 1 + \left( \alpha^i + \Gamma_{1,n-1} \right)x + \left( \alpha^{2i} + \alpha^i \Gamma_{1,n-1} + \Gamma_{2,n-1} \right)x^2 + \ldots + \sum_{j=0}^{M-1} \alpha^{ij} \Gamma_{M-1-j,n-1} x^{M-1} \right)$$
$$+ v_n \left( 1 + \left( \alpha^n + \Gamma_{1,n-1} \right)x + \left( \alpha^{2n} + \alpha^n \Gamma_{1,n-1} + \Gamma_{2,n-1} \right)x^2 + \ldots + \sum_{i=0}^{M-1} \alpha^{ni} \Gamma_{M-1-i,n-1} x^{M-1} \right) \tag{24}$$

$$T_*(x) = \sum_{i=0}^{n} v_i \left( 1 + \left( \alpha^i + \Gamma_{1,n-1} \right)x + \left( \alpha^{2i} + \alpha^i \Gamma_{1,n-1} + \Gamma_{2,n-1} \right)x^2 + \ldots + \sum_{j=0}^{M-1} \alpha^{ij} \Gamma_{M-1-j,n-1} x^{M-1} \right) \tag{25}$$

Now Equation (21) is computed

$$T_n(x) = \left( \sum_{i=0}^{n} v_i \left( 1 + \left( \alpha^i + \Gamma_{1,n-1} \right)x + \left( \alpha^{2i} + \alpha^i \Gamma_{1,n-1} + \Gamma_{2,n-1} \right)x^2 + \ldots + \sum_{j=0}^{M-1} \alpha^{ij} \Gamma_{M-1-j,n-1} x^{M-1} \right) \right)\left( 1 - \alpha^n x \right)$$

Using cyclic convolution again yields

$$T_n(x) = \sum_{i=0}^{n} v_i \left( 1 + \left( \alpha^i + \underbrace{\alpha^n + \Gamma_{1,n-1}}_{\Gamma_{1,n}} \right) x + \left( \alpha^{2i} + \alpha^i \underbrace{(\alpha^n + \Gamma_{1,n-1})}_{\Gamma_{1,n}} + \underbrace{\alpha^n \Gamma_{1,n-1} + \Gamma_{2,n-1}}_{\Gamma_{2,n}} \right) x^2 + \dots \right.$$
$$\left. + \sum_{j=0}^{M-1} \alpha^{ij} \underbrace{(\alpha^n \Gamma_{M-j,n-1} + \Gamma_{M-1-j,n-1})}_{\Gamma_{M-1-j,n}} x^{M-1} \right) \qquad (26)$$

which can be rewritten as

$$T_n(x) = \sum_{i=0}^{n} v_i \left( 1 + (\alpha^i + \Gamma_{1,n}) x + (\alpha^{2i} + \alpha^i \Gamma_{1,n} + \Gamma_{2,n}) x^2 + \dots + \sum_{j=0}^{M-1} \alpha^{ij} \Gamma_{M-1-j,n} x^{M-1} \right). \qquad (27)$$

This is in fact again the linear convolution of the syndrome and erasure polynomial, according to Equation (19).

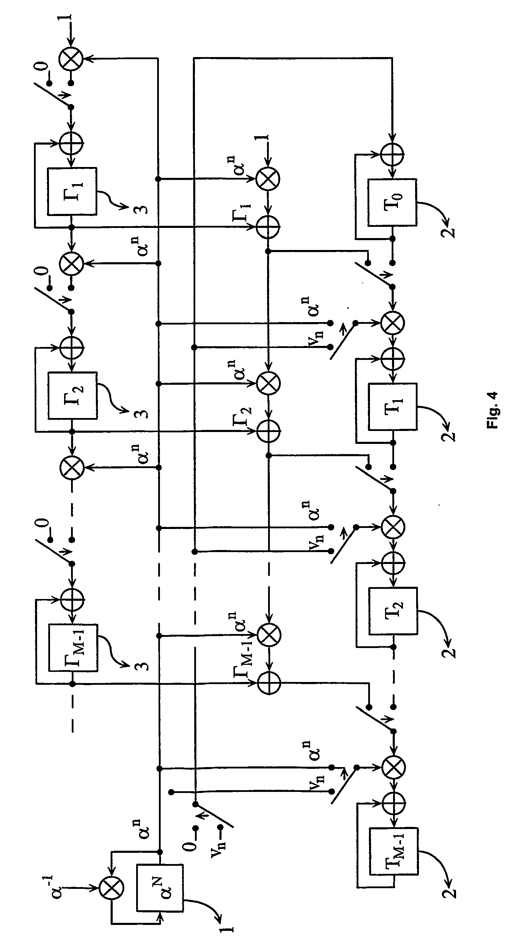

An embodiment of algorithm A for on-the-fly computation of the modified syndrome can be seen in Figure 4. If the switches are in their depicted position, the architecture realizes the computation according to Equation (20). If the switches are toggled, the architecture realizes the computation according to Equation (21).

The switches are realized as combinatorial logic; hence they do not cause any extra clock delay. By comparison with the embodiments of Figure 1 and Figure 2 it can easily be seen that there is only an additional adder per cell or register necessary. That means there is a reduction in hardware, because no additional polynomial multiplier is necessary.

At the beginning of a new code sequence, register 1 in Figure 4 is initialised with the power of the position of the first symbol, for example with $\alpha^{181}$ for the example of the inner code of DVD. The registers 2 and 3 are initialised with zeros. At every rising edge of the symbol clock a new symbol arrives and register 1 is clocked, decreasing the root power by one. Afterwards registers 2 are clocked with the next falling edge of the symbol clock, which updates the syndromes according to Equation (20).

If the arrived symbol was signalled as an erasure, the switches are toggled and registers 2 and 3 are clocked again, computing Equation (21). At the end of the last symbol in the sequence, after the last computation, registers 2 hold the modified syndromes of the whole code sequence and registers 3 hold the erasure polynomial.

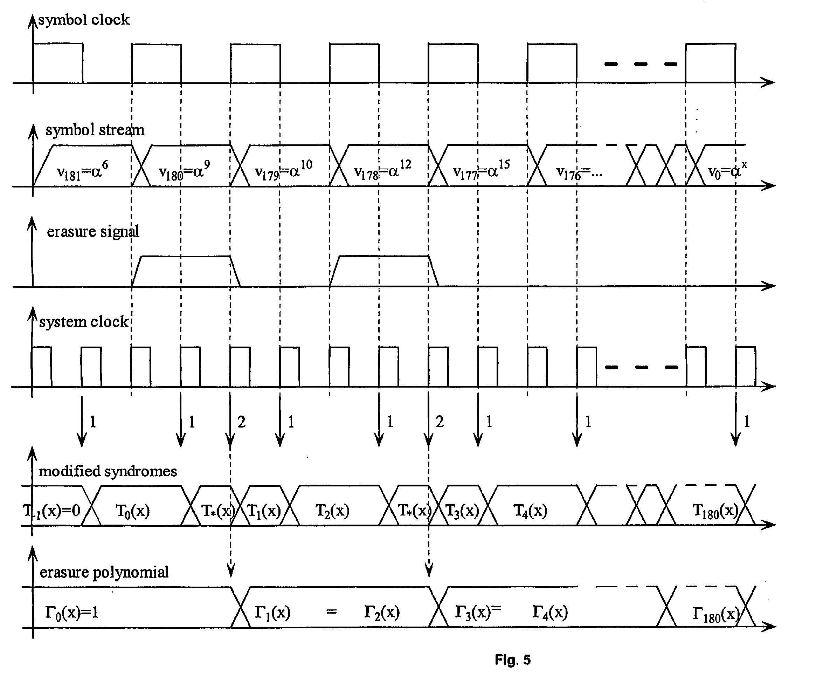

In the following reference is made to Figure 5, which shows an example for the timing behaviour of the method of Figure 3.

Assuming $M$ =10 and order goes downward, as it is the case for the inner code of DVD. The symbol order starts with 181 and goes down to 0. The registers are preloaded with $T(x)=0$ and $\Gamma_{-1}(x)=1$. Let us assume we receive the following data stream:

$$v_{181} = \alpha^6, v_{180}^* = \alpha^9, v_{179} = \alpha^{10}, v_{178}^* = \alpha^{12}, v_{177} = \alpha^{15}, v_{176} = \dots, \dots, v_0 = \alpha^{\dots},$$

where the $v_i^*$ shall indicate those symbols which are signalled as erasures. At every rising edge of the symbol clock we get a new symbol $v_n$ together with its erasure information as shown in Figure 5, and the register 1 of the circuit in Figure 4 is clocked and contains, the right power term $\alpha^n$ of that symbol. At the first system clock after the rising edge of the symbol clock, denoted as 1 in Figure 5, registers 2 of the circuit in Figure 4 are clocked in their depicted position and Equation (20) is computed.

If the erasure signal is true the switches in Figure 4 are toggled and registers 2 and 3 of the circuit are clocked again at the next rising edge of the system clock, denoted 2 in Figure 5, which leads to the computation of Equation (21). After the last computation of the 182nd symbol, the correct modified syndrome of the whole codeword is obtained. For the present example, the intermediate results up to after the fifth incoming symbol shall now be explained in detail.

*Conventional way:*

At first the intermediate modified syndrome is calculated in a conventional way as a reference to be able to verify the result of the inventive algorithm explained below. Equation (2) gives the syndrome of the data stream as

$$S(x) = \left(\alpha^6 + \alpha^9 + \alpha^{10} + \alpha^{12} + \alpha^{15}\right) + \left(\alpha^6\alpha^{181} + \alpha^9\alpha^{180} + \alpha^{10}\alpha^{179} + \alpha^{12}\alpha^{178} + \alpha^{15}\alpha^{177}\right)x + \dots$$
$$+ \left(\alpha^6\alpha^{9\cdot181} + \alpha^9\alpha^{9\cdot180} + \alpha^{10}\alpha^{9\cdot179} + \alpha^{12}\alpha^{9\cdot178} + \alpha^{15}\alpha^{9\cdot177}\right)x^9 \qquad (28)$$
$$= \alpha^{169} + \alpha^{79}x + \alpha^{113}x^2 + \alpha^{37}x^3 + \alpha^{194}x^4 + \alpha^{112}x^5 + \alpha^{239}x^6 + \alpha^{168}x^7 + \alpha^{174}x^8 + \alpha^{240}x^9.$$

$$\Gamma(x) = (1 - \alpha^{180}x)(1 - \alpha^{178}x) = 1 + \alpha^{228}x + \alpha^{103}x^2. \qquad (29)$$

By multiplying the two polynomials, the modified syndrome polynomial up to that symbol is obtained as

$$T(x) = S(x)\Gamma(x)\bmod x^M = \alpha^{69} + \left(\alpha^{79} + \alpha^{169}\alpha^{228}\right)x +$$
$$+ \left(\alpha^{113} + \alpha^{79}\alpha^{228} + \alpha^{169}\alpha^{103}\right)x^2 + \dots$$
$$\dots + \left(\alpha^{240} + \alpha^{174}\alpha^{228} + \alpha^{168}\alpha^{103}\right)x^9 \qquad (30)$$
$$= \alpha^{169} + \alpha^{134}x + \alpha^{119}x^2 + \alpha^{68}x^3 + \alpha^{128}x^4 + \alpha^{172}x^5 +$$
$$+ \alpha^{21}x^6 + \alpha^{40}x^7 + \alpha^{217}x^8 + \alpha^{152}x^9$$

*On-the-fly algorithm*

Computation is done in order of the incoming symbol; after each step, the resulting modified syndromes are correct up to the latest received symbol.

1. Getting data symbol $v_{181} = \alpha^6$; first system clock 1; computing Equation (20):

$$T_0(x) = \alpha^6\left(1 + \alpha^{181}x + \alpha^{2\cdot180}x^2 + \dots + \alpha^{9\cdot180}x^9\right)$$
$$= \alpha^6 + \alpha^{187}x + \alpha^{113}x^2 + \alpha^{39}x^3 + \alpha^{220}x^4 + \qquad (31)$$
$$+ \alpha^{146}x^5 + \alpha^{72}x^6 + \alpha^{253}x^7 + \alpha^{179}x^8 + \alpha^{105}x^9$$

$$\Gamma_0 = 1 \qquad (32)$$

2. Getting erasure symbol $v^*_{180} = \alpha^9$; first system clock 1; computing Equation (20):

$$T_*(x) = (\alpha^6 + \alpha^9) + (\alpha^{187} + \alpha^9 \alpha^{180})x + (\alpha^{113} + \alpha^9 \alpha^{2\cdot180})x^2 + \ldots$$
$$\ldots + (\alpha^{105} + \alpha^9 \alpha^{9\cdot180})x^9$$
$$= \alpha^{229} + \alpha^{237}x + \alpha^{138}x^2 + 0 \cdot x^3 + \alpha^{244}x^4 + \alpha^{194}x^5 +$$
$$+ \alpha^{37}x^6 + \alpha^{94}x^7 + \alpha^{57}x^8 + \alpha^{35}x^9 \qquad (33)$$

Second system clock 2, computing Equation (21):

$$T_1(x) = \alpha^{229} + (\alpha^{237} + \alpha^{180}\alpha^{229})x + (\alpha^{138} + \alpha^{180}\alpha^{237})x^2 + \ldots$$
$$\ldots + (\alpha^{35} + \alpha^{180}\alpha^{57})x^9$$
$$= \alpha^{229} + \alpha^{211}x + \alpha^{137}x^2 + \alpha^{63}x^3 + \alpha^{244}x^4 + \alpha^{170}x^5 +$$
$$+ \alpha^{96}x^6 + \alpha^{22}x^7 + \alpha^{203}x^8 + \alpha^{129}x^9 \qquad (34)$$

and

$$\Gamma_1(x) = 1 + \alpha^{180}x \qquad (35)$$

3. Getting data symbol $v_{179} = \alpha^{10}$; first system clock 1, computing Equation (20) :

$$T_2(x) = (\alpha^{229} + \alpha^{10}) + (\alpha^{211} + \alpha^{10}(\alpha^{179} + \alpha^{180}))x +$$
$$+ (\alpha^{137} + \alpha^{10}(\alpha^{2\cdot179} + \alpha^{179}\alpha^{180}))x^2 + \ldots$$
$$\ldots + (\alpha^{129} + \alpha^{10}(\alpha^{9\cdot179} + \alpha^{8\cdot179}\alpha^{180}))x^9$$
$$= \alpha^{199} + \alpha^{179}x + \alpha^{162}x^2 + \alpha^{87}x^3 + \alpha^{209}x^4 + \alpha^{48}x^5 +$$
$$+ \alpha^{201}x^6 + \alpha^{133}x^7 + \alpha^{182}x^8 + \alpha^{215}x^9 \qquad (36)$$

$$\Gamma_2(x) = 1 + \alpha^{180}x \qquad (37)$$

4. Getting erasure symbol $v_{178}^* = \alpha^{12}$; first system clock 1, computing Equation (20):

$$T_*(x) = (\alpha^{199} + \alpha^{12}) + (\alpha^{179} + \alpha^{12}(\alpha^{178} + \alpha^{180}))x +$$
$$+ (\alpha^{162} + \alpha^{12}(\alpha^{2\cdot178} + \alpha^{178}\alpha^{180}))x^2 + \ldots$$
$$\ldots + (\alpha^{215} + \alpha^{12}(\alpha^{9\cdot178} + \alpha^{8\cdot178}\alpha^{180}))x^9$$
$$= \alpha^{216} + \alpha^{110}x + \alpha^{187}x^2 + \alpha^{111}x^3 + \alpha^{17}x^4 + \alpha^{146}x^5 +$$
$$+ \alpha^{64}x^6 + \alpha^{37}x^7 + \alpha^{108}x^8 + \alpha^{39}x^9 \qquad (38)$$

Second system clock 2, computing Equation (21):

$$T_3(x) = \alpha^{216} + \left(\alpha^{110} + \alpha^{178}\alpha^{216}\right)x + \left(\alpha^{187} + \alpha^{178}\alpha^{110}\right)x^2 + \ldots$$
$$\ldots + \left(\alpha^{39} + \alpha^{178}\alpha^{108}\right)x^9$$
$$= \alpha^{216} + \alpha^{36}x + \alpha^{234}x^2 + \alpha^{135}x^3 + \alpha^{85}x^4 + \alpha^{88}x^5 + \alpha^{202}x^6 +$$
$$+ \alpha^{244}x^7 + \alpha^{166}x^8 + \alpha^{231}x^9$$

$$(39)$$

and

$$\Gamma_3(x) = 1 + \left(\alpha^{180} + \alpha^{178}\right)x + \alpha^{180}\alpha^{178}x^2$$
$$= 1 + \alpha^{228}x + \alpha^{103}x^2$$

$$(40)$$

5. Getting data symbol $v_{177} = \alpha^{15}$ ; first system clock 1; computing Equation (20):

$$T_4(x) = \left(\alpha^{216} + \alpha^{15}\right) + \left(\alpha^{36} + \alpha^{15}\left(\alpha^{177} + \alpha^{228}\right)\right)x +$$
$$+ \left(\alpha^{234} + \alpha^{15}\left(\alpha^{2\cdot177} + \alpha^{177}\alpha^{228} + \alpha^{103}\right)\right)x^2 + \ldots$$
$$\ldots + \left(\alpha^{231} + \alpha^{15}\left(\alpha^{9\cdot177} + \alpha^{8\cdot177}\alpha^{228} + \alpha^{7\cdot177}\alpha^{103}\right)\right)x^9$$
$$= \alpha^{169} + \alpha^{134}x + \alpha^{119}x^2 + \alpha^{68}x^3 + \alpha^{128}x^4 + \alpha^{172}x^5 +$$
$$+ \alpha^{21}x^6 + \alpha^{40}x^7 + \alpha^{217}x^8 + \alpha^{152}x^9$$

$$(41)$$

$$\Gamma_4(x) = 1 + \left(\alpha^{180} + \alpha^{178}\right)x + \alpha^{180}\alpha^{178}x^2$$
$$= 1 + \alpha^{228}x + \alpha^{103}x^2$$

$$(42)$$

Comparison of Equation (42) with (29) and (41) with (30) verifies the algorithm. This result is an intermediate result, it's not the final modified syndrome but merely the modified syndrome up to the fifth received symbol. The modified syndrome of the whole code sequence is obtained after the 182nd computation.

**Algorithm B**

In the following, the alternative algorithm B for the computation of the modified syndrome polynomials will be explained in more detail:

The second system clock at the computation of an erasure symbol can be avoided by inserting Equation (20) in Equation (21), which yields

$$T_n(x) = T_{n-1}(x)\left(1 - \alpha^n x\right)$$
$$+ v_n\left(1 + \left(\alpha^n + \Gamma_{1,n-1}\right)x + \left(\alpha^{2n} + \alpha^n\Gamma_{1,n-1} + \Gamma_{2,n-1}\right)x^2 + \ldots\right.$$
$$\left.\ldots + \sum_{j=0}^{M-1}\alpha^{nj}\Gamma_{M-1-j,n-1}x^{M-1}\right)\left(1 - \alpha^n x\right),$$

$$(43)$$

11

or better

$$T_n(x) = T_{n-1}(x)\left(1 - \alpha^n x\right)$$

$$+ v_n\left[ 1 + \underbrace{\left( \alpha^n + \underbrace{\alpha^n + \Gamma_{1,n-1}}_{\Gamma_{1,n}} \right)}_{\Gamma_{1,n-1}} x + \underbrace{\left( \alpha^{2n} + \alpha^n \underbrace{\left( \alpha^n + \Gamma_{1,n-1} \right)}_{\Gamma_{1,n}} + \underbrace{\alpha^n \Gamma_{1,n-1} + \Gamma_{2,n-1}}_{\Gamma_{2,n}} \right)}_{\Gamma_{2,n-1}} x^2 + \dots \right. \qquad (44)$$

$$\left. + \underbrace{\sum_{j=0}^{M-1} \alpha^{nj} \underbrace{\left( \alpha^n \Gamma_{M-j,n-1} + \Gamma_{M-1-j,n-1} \right)}_{\Gamma_{M-1-j,n}} x^{M-1}}_{\Gamma_{M-1,n-1}} \right]$$

Therefore the equation can be written as

$$T_n(x) = T_{n-1}(x)\left(1 - \alpha^n x\right) + v_n \Gamma_{n-1}(x), \quad \text{where} \quad \Gamma_{-1}(x) = 1 \qquad (45)$$

Now it is possible to write down the second algorithm B, which needs only one system clock for every incoming symbol type.

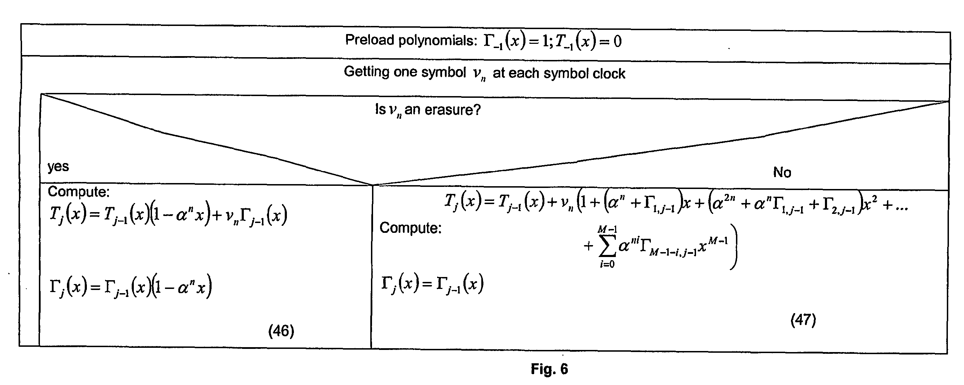

The flowchart in Figure 6 shows the second embodiment of an on-the-fly computation. For calculating one iteration result $T_j(x)$, $\Gamma_j(x)$, the flowchart comprises Equation (46) used in case the incoming symbol $v_n$ is an erasure, and Equation (47) used otherwise.

At each symbol clock, when a new symbol is obtained, the modified syndromes are updated. At every step of the calculation, the resulting modified syndromes are correct up to the latest received symbol. For that algorithm B the system clock rate can be the same as the symbol clock rate, which yields to a very fast computation. The algorithm ends after the last symbol, then the correct modified syndrome is obtained.

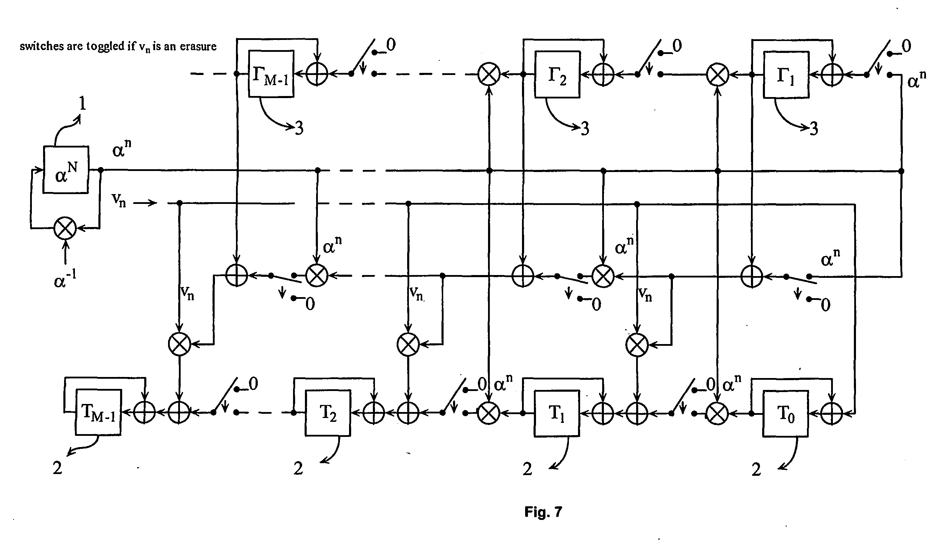

A second embodiment of an on-the-fly computation of the modified syndrome is depicted in Figure 7. If the switches are in their depicted position, the architecture realizes the computation according to Equation (47). If the switches are toggled, the architecture realizes the computation according to Equation (46).

The switches are realized as combinatorial logic; hence they do not cause any extra clock delay. Comparing the depicted architecture with the one in Figure 4, an additional multiplier and adder per cell or register is necessary. Increasing the hardware structure and therefore increasing the latency time can achieve reduction of computation time.

At the beginning of a new code sequence, register 1 in Figure 7 is initialised with the power of the position of the first symbol, for example with $\alpha^{181}$ for the example of the inner code of DVD. The registers 2 and 3 are initialised with zeros. The switches are directly connected to the erasure signal. All registers 1, 2 and 3 are clocked with the rising edge of the symbol clock, which updates the syndromes according to Equation (46) or (47), depending on the erasure signal.

The clocking of register 1 decreases the power of the root term by one, in preparation for the next symbol. At the end of the last symbol in the sequence, after the last computation, registers 2 hold the modified syndromes of the whole code sequence and registers 3 hold the erasure polynomial.

The timing behaviour and the algorithm are now explained by way of example. Assuming $M=10$ and order goes downward, as it is the case for the inner code of DVD. The symbol order starts with 181 and goes down to 0. The registers are preloaded with $T(x)=0$ and $\Gamma_{-1}(x)=1$. Let us assume we receive the following data stream:

$$v_{181} = \alpha^6, v_{180}^* = \alpha^9, v_{179} = \alpha^{10}, v_{178}^* = \alpha^{12}, v_{177} = \alpha^{15}, v_{176} = \dots,\dots, v_0 = \alpha^{\cdots},$$

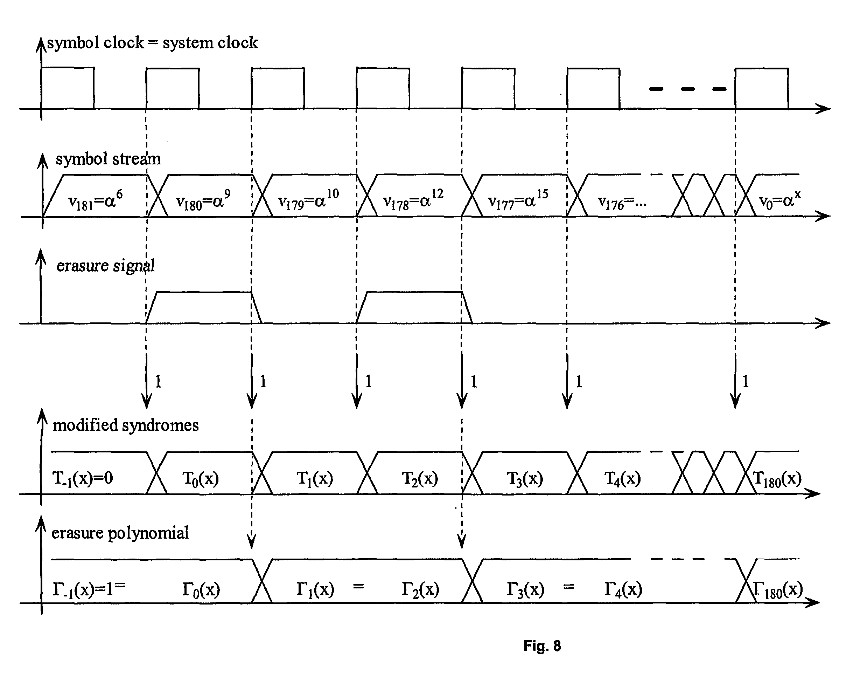

where the $v_i^*$ shall indicate those symbols which are signalled as erasures. At every rising edge of the system clock a new symbol $v_n$ and an erasure information as shown in Figure 8 is obtained.

The erasure signal feeds the switches of the circuit in Figure 7. If the erasure signal is false the switches remain in their depicted position, if the erasure signal is true the switches are toggled. At the rising edge of the system clock, denoted as 1 in Figure 8, the circuit in Figure 7 is clocked and Equation (46) or (47) is computed. After the last, i.e. 182nd symbol clock, the correct modified syndrome of the whole codeword is obtained. For the present example, the intermediate results up to after the fifth incoming symbol shall now be explained in detail.

Computation is done in order of the incoming symbols; after each step, the resulting modified syndromes are correct up to the latest received symbol.

1. Getting data symbol $v_{181} = \alpha^6$; computing Equation (46):

$$
\begin{aligned}
T_0(x) &= \alpha^6\left(1 + \alpha^{181}x + \alpha^{2\cdot180}x^2 + \ldots + \alpha^{9\cdot180}x^9\right) \\
&= \alpha^6 + \alpha^{187}x + \alpha^{113}x^2 + \alpha^{39}x^3 + \alpha^{220}x^4 + \\
&\quad + \alpha^{146}x^5 + \alpha^{72}x^6 + \alpha^{253}x^7 + \alpha^{179}x^8 + \alpha^{105}x^9
\end{aligned}
\tag{48}
$$

$$
\Gamma_0 = 1
\tag{49}
$$

2. Getting erasure symbol $v_{180}^* = \alpha^9$; computing Equation (47):

$$
\begin{aligned}
T_1(x) &= \alpha^6\left(1 + \alpha^{181}x + \alpha^{2\cdot180}x^2 + \ldots + \alpha^{9\cdot180}x^9\right) \\
&= \alpha^6 + \left(\alpha^{187} + \alpha^{180}\alpha^6\right)x + \left(\alpha^{113} + \alpha^{180}\alpha^{187}\right)x^2 + \ldots \\
&\quad \ldots + \left(\alpha^{105} + \alpha^{180}\alpha^{179}\right)x^9 + \alpha^9 \\
&= \alpha^{229} + \alpha^{211}x + \alpha^{137}x^2 + \alpha^{63}x^3 + \alpha^{244}x^4 + \alpha^{170}x^5 + \\
&\quad + \alpha^{96}x^6 + \alpha^{22}x^7 + \alpha^{203}x^8 + \alpha^{129}x^9
\end{aligned}
\tag{50}
$$

and

$$
\Gamma_1(x) = 1 + \alpha^{180}x
\tag{51}
$$

3. Getting data symbol $v_{179} = \alpha^{10}$; computing Equation (46):

$$
\begin{aligned}
T_2(x) &= \left(\alpha^{229} + \alpha^{10}\right) + \left(\alpha^{211} + \alpha^{10}\left(\alpha^{179} + \alpha^{180}\right)\right)x + \\
&\quad + \left(\alpha^{137} + \alpha^{10}\left(\alpha^{2\cdot179} + \alpha^{179}\alpha^{180}\right)\right)x^2 + \ldots \\
&\quad \ldots + \left(\alpha^{129} + \alpha^{10}\left(\alpha^{9\cdot179} + \alpha^{8\cdot179}\alpha^{180}\right)\right)x^9 \\
&= \alpha^{199} + \alpha^{179}x + \alpha^{162}x^2 + \alpha^{87}x^3 + \alpha^{209}x^4 + \\
&\quad + \alpha^{48}x^5 + \alpha^{201}x^6 + \alpha^{133}x^7 + \alpha^{182}x^8 + \alpha^{215}x^9
\end{aligned}
\tag{52}
$$

$$\Gamma_2(x) = 1 + \alpha^{180} x \tag{53}$$

4. Getting erasure symbol $\overset{*}{v}_{178} = \alpha^{12}$ ; computing Equation (47) :

$$T_3(x) = \alpha^{199} + \left(\alpha^{179} + \alpha^{178}\alpha^{199}\right)x + \left(\alpha^{162} + \alpha^{178}\alpha^{179}\right)x^2 + \ldots$$
$$\ldots + \left(\alpha^{215} + \alpha^{178}\alpha^{182}\right)x^9$$
$$+ \alpha^{12} + \alpha^{12}\alpha^{180}x \tag{54}$$
$$= \alpha^{216} + \alpha^{36}x + \alpha^{234}x^2 + \alpha^{135}x^3 + \alpha^{85}x^4 + \alpha^{88}x^5 + \alpha^{202}x^6 +$$
$$+ \alpha^{244}x^7 + \alpha^{166}x^8 + \alpha^{231}x^9$$

and

$$\Gamma_3(x) = 1 + \left(\alpha^{180} + \alpha^{178}\right)x + \alpha^{180}\alpha^{178}x^2$$
$$= 1 + \alpha^{228}x + \alpha^{103}x^2 \tag{55}$$

5. Getting data symbol $v_{in} = \alpha^{15}$; computing Equation (46) :

$$T_4(x) = \left(\alpha^{216} + \alpha^{15}\right) + \left(\alpha^{36} + \alpha^{15}\left(\alpha^{177} + \alpha^{228}\right)\right)x +$$
$$+ \left(\alpha^{234} + \alpha^{15}\left(\alpha^{2\cdot177} + \alpha^{177}\alpha^{228} + \alpha^{103}\right)\right)x^2 +$$
$$+ \left(\alpha^{231} + \alpha^{15}\left(\alpha^{9\cdot177} + \alpha^{8\cdot177}\alpha^{228} + \alpha^{7\cdot177}\alpha^{103}\right)\right)x^9 \tag{56}$$
$$= \alpha^{169} + \alpha^{134}x + \alpha^{119}x^2 + \alpha^{68}x^3 + \alpha^{128}x^4 + \alpha^{172}x^5 +$$
$$+ \alpha^{21}x^6 + \alpha^{40}x^7 + \alpha^{217}x^8 + \alpha^{152}x^9$$

$$\Gamma_4(x) = 1 + \left(\alpha^{180} + \alpha^{178}\right)x + \alpha^{180}\alpha^{178}x^2$$
$$= 1 + \alpha^{228}x + \alpha^{103}x^2 \tag{57}$$

Comparison of Equation (56) with (29) and (57) with (30) verifies the algorithm. This result is an intermediate result, it is not the finally modified syndrome, it is the modified syndrome up to that symbol. The modified syndrome of the whole code sequence is obtained after the 182nd computation.

## Claims

1. A method for soft-decision decoding of Reed-Solomon codewords consisting of N symbols, the generator polynomial of the Reed-Solomon code having M roots,
**characterized by**
computing a syndrome polynomial, an erasure polynomial $\Gamma(x)$ and a modified syndrome polynomial $T(x)$ in parallel by iteratively updating coefficients of said polynomials at each symbol clock a new data symbol is arriving, such that the polynomials for a codeword are obtained directly after the coefficient updating for the last symbol of the codeword has been performed.

2. The method of claim 1 comprising the steps of:

- computing the syndrome polynomial S(x) as

$$S(x) = \sum_{i=0}^{N-1} v_i + \sum_{i=0}^{N-1} v_i \alpha^i x + \sum_{i=0}^{N-1} v_i \alpha^{2i} x^2 + \ldots + \sum_{i=0}^{N-1} v_i \alpha^{(M-1)i} x^{M-1},$$

where the $v_i$ are the incoming data symbols;

- computing the erasure polynomial $\Gamma(x)$ as

$$\Gamma(x) = \prod_{i=0}^{p-1} \left(1 - \alpha^{j_i} x\right),$$

where $\alpha^{j_i}$ is the power of the positions $j_0, j_1, \ldots, j_{p-1}$ of the erasures and p is the number of erasures in the code-word;

- constructing the modified syndrome polynomial in a way which obtains the correct modified syndrome

$$T(x) = \Gamma(x) S(x) \bmod x^M$$

after the computation for the last symbol,
- determining polynomials $\Lambda(x)$, $\Omega(x)$ by solving the key equation

$$\Lambda(x) T(x) = \Omega(x) \bmod x^M$$

with Berlekamp-Massey or Euclid's algorithm,
- computing the Forney polynomial

$$\Psi(x) = \Lambda(x) \Gamma(x)$$

- computing the magnitude of the errors and erasures using the Forney equation.

3. The method of claim 2, whereby the computation of the erasure polynomial and the modified syndrome polynomial is performed on-the-fly with the incoming data symbols $v_{N-1}, \ldots, v_1, v_0$.

4. The method of anyone of the preceding claims 1, 2 or 3, whereby the syndrome polynomial is computed in the form

$$S(x) = \sum_{i=0}^{N-1} v_i + \sum_{i=0}^{N-1} v_i \alpha^i x + \sum_{i=0}^{N-1} v_i \alpha^{2i} x^2 + \ldots + \sum_{i=0}^{N-1} v_i \alpha^{(M-1)i} x^{M-1}$$

$$= S_0 + S_1 x + S_2 x^2 + \ldots + S_{M-1} x^{M-1}.$$

by iteratively updating the coefficients $S_i, i = 0,1,\ldots,M-1$, whereby at each symbol clock j when a new symbol $v_n$ is arriving, the power $\alpha^n$ of the position $n$ is computed and the coefficients are updated in the following way

$$S_{i,j} = S_{i,j-1} + v_n \alpha^{in} , \quad i = 0,1,...,M-1$$

where $S_{i,-1} = 0$ .

5. The method of anyone of the preceding claims 1 to 4, whereby the erasure polynomial is computed on-the-fly by iteratively updating the polynomial

$$\Gamma(x) = \prod_{i=0}^{p-1}\left(1 - \alpha^{j_i}x\right)$$
$$= \Gamma_0 + \Gamma_1 x + \Gamma_2 x^2 + ... + \Gamma_p x^p$$

whereby the updating is performed at each symbol clock $j_i$ when a new arriving symbol is being flagged as an erasure, the power $\alpha^{j_i}$ of the erasure position $j_i$ is computed and the polynomial is updated in the following way

$$\Gamma_j(x) = \Gamma_{j-1}(x) \cdot \left(1 - \alpha^{j_i}x\right) = \left(\Gamma_{0,j-1} + \Gamma_{1,j-1}x + ... + \Gamma_{p,j-1}x^p\right)\left(1 - \alpha^{j_i}x\right).$$

6. The method of anyone of the preceding claims 1 to 5, the computing of the modified syndrome polynomial $T(x)$ being performed directly by the steps of:

 - preloading of polynomials $\Gamma_{-1}(x)=1$; $T_{-1}(x)=0$;
 - getting one symbol $v_n$ at each symbol clock;
 - computing at a first system clock within the symbol clock:

$$T_*(x) = T_{j-1}(x) + v_n\left(1 + \left(\alpha^n + \Gamma_{1,j-1}\right)x + \left(\alpha^{2n} + \alpha^n\Gamma_{1,j-1} + \Gamma_{2,j-1}\right)x^2 + ... \right.$$
$$\left. + \sum_{i=0}^{M-1}\alpha^{ni}\Gamma_{M-1-i,j-1}x^{M-1}\right) \quad ;$$

$$\Gamma_*(x) = \Gamma_{j-1}(x)$$

 - determining if $v_n$ is an erasure;
 - If Yes: Computing at a second system clock within the symbol clock:

$$T_j(x) = T_*(x)\left(1 - \alpha^n x\right)$$
$$\Gamma_j(x) = \Gamma_{j-1}(x)\left(1 - \alpha^n x\right) \quad ;$$

 - if no: using

$$T_j(x) = T_*(x)$$

$$\Gamma_j(x) = \Gamma_*(x)$$

7. The method of anyone of the preceding claims 1 to 5, the computation of the modified syndrome polynomial $T(x)$ involving, in cases where an incoming symbol is flagged as an erasure, an on-the-fly updating step in the form:

$$T_n(x) = T_{n-1}(x)(1 - \alpha^n x) + v_n \Gamma_{n-1}(x),$$

where $\Gamma_{-1}(x) = 1$.

8. The method of anyone of the preceding claims 1 to 5 or 7, the modified syndrome polynomial $T(x)$ being computed on-the-fly by the steps of:

- preloading of polynomials $\Gamma_{-1}(x) = 1$; $T_{-1,}(x) = 0$,
- getting one symbol $v_n$ at each symbol clock,
- determining if $v_n$ is an erasure,
- if Yes: Computing

$$T_j(x) = T_{j-1}(x)(1 - \alpha^n x) + v_n \Gamma_{j-1}(x)$$

$$\Gamma_j(x) = \Gamma_{j-1}(x)(1 - \alpha^n x) \quad ;$$

- if No: computing

$$T_j(x) = T_{j-1}(x) + v_n \left( 1 + (\alpha^n + \Gamma_{1,j-1})x + (\alpha^{2n} + \alpha^n \Gamma_{1,j-1} + \Gamma_{2,j-1})x^2 + \ldots \right.$$
$$\left. + \sum_{i=0}^{M-1} \alpha^{ni} \Gamma_{M-1-i,j-1} x^{M-1} \right)$$

$$\Gamma_j(x) = \Gamma_{j-1}(x) \quad .$$

9. A computer program product, such as a digital storage medium, comprising program means for soft-decision decoding of Reed-Solomon codewords, the program means being adapted for computing of a syndrome polynomial, an erasure polynomial and a modified syndrome polynomial in parallel by iteratively updating coefficients of said polynomials at each symbol clock when a new data symbol is arriving, such that the polynomials for a codeword are obtained directly after the coefficient updating for the last symbol of the codeword has been performed.

10. A Reed-Solomon codeword decoder comprising means for computation of a syndrome polynomial, an erasure polynomial and a modified syndrome polynomial in parallel by iteratively updating coefficients of said polynomials at each symbol clock when a new data symbol is arriving, such that the polynomials for a codeword are obtained directly after the coefficient updating for the last symbol of the codeword has been performed.

**Patentansprüche**

1. Verfahren zur Soft-Entscheidungs-Decodierung von Reed-Solomon-Codewörtern, die aus N Symbolen bestehen, wobei das Generatorpolynom des Reed-Solomon-Codes M Wurzeln aufweist,
   **gekennzeichnet durch**
   paralleles Berechnen eines Syndrompolynoms, eines Löschungspolynoms $\Gamma(x)$ und eines modifizierten Syndrompolynoms $T(x)$ **durch** iteratives Aktualisieren von Koeffizienten der Polynome bei jedem Symboltakt, an dem ein neues Datensymbol ankommt, dergestalt, daß die Polynome für ein Codewort direkt erhalten werden, nachdem die Koeffizientenaktualisierung für das letzte Symbol des Codeworts durchgeführt wurde.

2. Verfahren nach Anspruch 1 mit den folgenden Schritten:

   - Berechnen des Syndrompolynoms S(x) als

   $$S(x) = \sum_{i=0}^{N-1} v_i + \sum_{i=0}^{N-1} v_i \alpha^i x + \sum_{i=0}^{N-1} v_i \alpha^{2i} x^2 + \dots + \sum_{i=0}^{N-1} v_i \alpha^{(M-1)i} x^{M-1},$$

   wobei die $v_i$ die ankommenden Datensymbole sind;
   - Berechnen des Löschungspolynoms $\Gamma(x)$ als

   $$\Gamma(x) = \prod_{i=0}^{p-1} \left(1 - \alpha^{j_i} x\right),$$

   wobei $\alpha^{j_i}$ die Potenz der Positionen $j_0, j_1, \dots, j_{p-1}$ der Löschungen und p die Anzahl der Löschungen in dem Codewort ist;
   - Konstruieren des modifizierten Syndrompolynoms auf eine Weise, die das korrekte modifizierte Syndrom

   $$T(x) = \Gamma(x) S(x) \bmod x^M$$

   erhält, nach der Berechnung für das letzte Symbol,
   - Bestimmen der Polynome $\Lambda(x)$, $\Omega(x)$ durch Auslösen der Schlüsselgleichung

   $$\Lambda(x) T(x) = \Omega(x) \bmod x^M$$

   mit dem Algorithmus von Berlekamp-Massey oder Euklid,
   - Berechnen des Forney-Polynoms

   $$\Psi(x) = \Lambda(x) \Gamma(x)$$

   - Berechnen des Betrags der Fehler und Löschungen unter Verwendung der Forney-Gleichung.

3. Verfahren nach Anspruch 2, wobei die Berechnung des Löschungspolynoms und des modifizierten Syndrompolynoms im Verlauf mit den ankommenden Datensymbolen

   $$v_{N-1}, \dots, v_1, v_0.$$

   durchgeführt wird.

4. Verfahren nach einem der vorherigen Ansprüche 1, 2 oder 3, wobei das Syndrompolynom in der folgenden Form

berechnet wird:

$$S(x) = \sum_{i=0}^{N-1} v_i + \sum_{i=0}^{N-1} v_i \alpha^i x + \sum_{i=0}^{N-1} v_i \alpha^{2i} x^2 + \ldots + \sum_{i=0}^{N-1} v_i \alpha^{(M-1)i} x^{M-1}$$
$$= S_0 + S_1 x + S_2 x^2 + \ldots + S_{M-1} x^{M-1}.$$

indem die Koeffizienten $S_i$, $i=0,1,\ldots,M-1$ iterativ aktualisiert werden, wobei bei jedem Symboltakt j, wenn ein neues Symbol $v_n$ ankommt, die Potenz $\alpha^n$ der Position $n$ berechnet wird und die Koeffizienten auf die folgende Weise aktualisiert werden:

$$S_{i,j} = S_{i,j-1} + v_n \alpha^{in}, \quad i = 0,1,\ldots,M-1$$

mit $S_{i,-1} = 0$.

**5.** Verfahren nach einem der vorhergehenden Ansprüche 1 bis 4, wobei das Löschungspolynom im Verlauf durch iteratives Aktualisieren des Polynoms

$$\Gamma(x) = \prod_{i=0}^{P-1} \left(1 - \alpha^{j_i} x\right)$$
$$= \Gamma_0 + \Gamma_1 x + \Gamma_2 x^2 + \ldots + \Gamma_P x^P$$

berechnet wird, wobei das Aktualisieren an jedem Symboltakt $j_i$ durchgeführt wird, wenn ein neues ankommendes Symbol als eine Löschung **gekennzeichnet** wird, die Potenz $\alpha^{j_i}$ der Löschungsposition $j_i$ berechnet wird und das Polynom auf die folgende Weise aktualisiert wird:

$$\Gamma_j(x) = \Gamma_{j-1}(x) \cdot \left(1 - \alpha^{j_i} x\right) = \left(\Gamma_{0,j-1} + \Gamma_{1,j-1} x + \ldots + \Gamma_{P,j-1} x^P\right)\left(1 - \alpha^{j_i} x\right).$$

**6.** Verfahren nach einem der vorhergehenden Ansprüche 1 bis 5, wobei das Berechnen des modifizierten Syndrompolynoms $T(x)$ direkt durch die folgenden Schritte durchgeführt wird:

   - Vorladen von Polynomen $\Gamma_{-1}(x)=1$; $T_{-1}(x)=0$;
   - Erhalten von einem Symbol $v_n$ an jedem Symboltakt;
   - Berechnen von folgendem mit dem ersten Systemtakt innerhalb des Symboltakts:

$$T_i(x) = T_{j-1}(x) + v_n \left(1 + \left(\alpha^n + \Gamma_{1,j-1}\right)x + \left(\alpha^{2n} + \alpha^n \Gamma_{1,j-1} + \Gamma_{2,j-1}\right)x^2 + \ldots \right.$$
$$\left. + \sum_{i=0}^{M-1} \alpha^{ni} \Gamma_{M-1-i,j-1} x^{M-1}\right) ;$$

$$\Gamma_i(x) = \Gamma_{j-1}(x)$$

   - Bestimmen, ob $v_n$ eine Löschung ist;
   - wenn ja: Berechnen von folgendem mit einem zweiten Systemtakt innerhalb des Symboltakts:

$$T_j(x) = T_i(x)\left(1 - \alpha^n x\right)$$
$$\Gamma_j(x) = \Gamma_{j-1}(x)\left(1 - \alpha^n x\right) ;$$

- wenn nein: Verwenden von

$$T_j(x) = T_*(x)$$

$$\Gamma_j(x) = \Gamma_*(x)$$

**7.** Verfahren nach einem der vorherigen Ansprüche 1 bis 5, wobei die Berechnung des modifizierten Syndrompolynoms $T(x)$, falls ein ankommendes Symbol als eine Löschung **gekennzeichnet** ist, einen Schritt des Aktualisierens im Verlauf in der folgenden Form umfaßt:

$$T_n(x) = T_{n-1}(x)(1 - \alpha^n x) + v_n \Gamma_{n-1}(x), \text{ where } \Gamma_{-1}(x) = 1 .$$

**8.** Verfahren nach einem der vorhergehenden Ansprüche 1 bis 5 oder 7, wobei das modifizierte Syndrompolynom $T(x)$ im Verlauf durch die folgenden Schritte berechnet wird:

- Vorladen von Polynomen $\Gamma_{-1}(x) = 1$; $T_{-1}(x) = 0$;
- Erhalten eines Symbols $v_n$ an jedem Symboltakt;
- Bestimmen, ob $v_n$ eine Löschung ist,
- wenn ja: Berechnen von

$$T_j(x) = T_{j-1}(x)(1 - \alpha^n x) + v_n \Gamma_{j-1}(x)$$

$$\Gamma_j(x) = \Gamma_{j-1}(x)(1 - \alpha^n x) ;$$

- wenn nein: Berechnen von

$$T_j(x) = T_{j-1}(x) + v_n \left( 1 + (\alpha^n + \Gamma_{1,j-1})x + (\alpha^{2n} + \alpha^n \Gamma_{1,j-1} + \Gamma_{2,j-1})x^2 + \ldots + \sum_{i=0}^{M-1} \alpha^{ni} \Gamma_{M-1-i,j-1} x^{M-1} \right)$$

$$\Gamma_j(x) = \Gamma_{j-1}(x) .$$

**9.** Computerprogrammprodukt wie etwa ein digitales Speichermedium mit Programmmitteln zur Soft-Entscheidungs-Decodierung von Reed-Solomon-Codewörtern, wobei die Programmmittel dafür ausgelegt sind, parallel ein Syndrompolynom, ein Löschungspolynom und ein modifiziertes Syndrompolynom zu berechnen, indem Koeffizienten der Polynome iterativ bei jedem Symboltakt aktualisiert werden, wenn ein neues Datensymbol ankommt, dergestalt, daß die Polynome für ein Codewort direkt erhalten werden, nachdem die Koeffizientenaktualisierung für das letzte Symbol des Codeworts durchgeführt wurde.

**10.** Reed-Solomon-Codewort-Decoder mit Mitteln zum parallelen Berechnen eines Syndrompolynoms, eines Löschungspolynoms und eines modifizierten Syndrompolynoms durch iteratives Aktualisieren von Koeffizienten der Polynome bei jedem Symboltakt, wenn ein neues Datensymbol ankommt, dergestalt, daß die Polynome für ein Codewort direkt erhalten werden, nachdem die Koeffizientenaktualisierung für das letzte Symbol des Codeworts durchgeführt wurde.

**EP 1 502 356 B1**

**Revendications**

1. Procédé de décodage à décision souple de mots de code de Reed-Solomon, consistant en N symboles, le polynôme générateur du code de Reed-Solomon ayant M racines
**caractérisé par**
le calcul d'un polynôme syndrome, d'un polynôme d'effacement $\Gamma(x)$ et d'un polynôme syndrome modifié $T(x)$ en parallèle en mettant à jour itérativement les coefficients desdits polynômes à chaque horloge symbole lorsqu'un nouveau symbole de données arrive, de sorte que les polynômes pour un mot de code soient obtenus directement après que la mise à jour des coefficients pour le dernier symbole du mot de code a été effectuée,

2. Le procédé selon la revendication 1, comprenant les étapes de :

   - calcul du polynôme syndrome S(x) sous la forme

$$S(x) = \sum_{i=0}^{N-1} v_i + \sum_{i=0}^{N-1} v_i \alpha^i x + \sum_{i=0}^{N-1} v_i \alpha^{2i} x^2 + ... + \sum_{i=0}^{N-1} v_i \alpha^{(M-1)i} x^{M-1},$$

   où les $v_i$ sont les symboles de données entrants;
   - calcul du polynôme d'effacement $\Gamma(x)$ sous la forme

$$\Gamma(x) = \prod_{i=0}^{p-1}\left(1 - \alpha^{j_i} x\right),$$

   où $\alpha^{j_i}$ est la puissance des positions $j_0, j_1,..., j_{p-1}$ des effacements et p est le nombre d'effacements dans le mot de code;
   - construction du polynôme syndrome modifié de manière à obtenir le syndrome modifié correct

$$T(x) = \Gamma(x)S(x) \bmod x^M,$$

   après le calcul du dernier symbole,
   - détermination des polynômes $\Lambda(x)$, $\Omega(x)$ en résolvant l'équation clé

$$\Lambda(x)T(x) = \Omega(x) \bmod x^M$$

   avec l'algorithme de Berlekamp-Massey ou celui d'Euclide
   - calcul du polynôme de Forney

$$\Psi(x) = \Lambda(x)\Gamma(x)$$

   - calcul de l'amplitude des erreurs et des effacements à l'aide de l'équation de Forney.

3. Le procédé de la revendication 2, dans lequel le calcul du polynôme d'effacement et du polynôme syndrome modifié est effectué à la volée avec les symboles de données entrants $v_{N-1},...,v_1,v_0$.

4. Le procédé de l'une quelconque des revendications précédentes 1, 2 ou 3, dans lequel le polynôme syndrome est calculé sous la forme

$$S(x) = \sum_{i=0}^{N-1} v_i + \sum_{i=0}^{N-1} v_i \alpha^i x + \sum_{i=0}^{N-1} v_i \alpha^{2i} x^2 + ... + \sum_{i=0}^{N-1} v_i \alpha^{(M-1)i} x^{M-1}$$
$$= S_0 + S_1 x + S_2 x^2 + ... + S_{M-1} x^{M-1},$$

en mettant à jour itérativement les coefficients $S_i$, $i=0,1,...,M-1$, moyennant quoi à chaque horloge symbole j, lorsqu'un nouveau symbole $\nu_n$ arrive, la puissance $\alpha^n$ de la position $n$ est calculée et les coefficients sont mis à jour de la manière suivante

$$S_{i,j} = S_{i,j-1} + \nu_n \alpha^{in}, \; i = 0,1,...,M-1$$

où $S_{i,-1} = 0$.

**5.** Le procédé de l'une quelconque des revendications précédentes 1 à 4, dans lequel le polynôme d'effacement est calculé à la volée en mettant à jour itérativement le polynôme

$$\Gamma(x) = \prod_{i=0}^{p-1} \left(1 - \alpha^{j_i} x\right)$$
$$= \Gamma_0 + \Gamma_1 x + \Gamma_2 x^2 + ... + \Gamma_p x^p$$

au moyen duquel la mise à jour est effectuée à chaque horloge symbole $j_i$ lorsqu'un nouveau symbole arrivant est signalé comme un effacement par un indicateur, la puissance $\alpha^{j_i}$ de la position d'effacement $j_i$ est calculée et le polynôme est mis à jour de la manière suivante

$$\Gamma_j(x) = \Gamma_{j-1}(x) \cdot \left(1 - \alpha^{j_i} x\right) = \left(\Gamma_{0,j-1} + \Gamma_{1,j-1} x + ... + \Gamma_{p,j-1} x^p\right)\left(1 - \alpha^{j_i} x\right).$$

**6.** Le procédé de l'une quelconque des revendications précédentes 1 à 5, le calcul du polynôme syndrome modifié étant effectué par les étapes de :

- pré-charge des polynômes $\Gamma_{-1}(x) = 1$; $T_{-1}(x) = 0$ ;
- obtention d'un symbole $\nu_n$ à chaque horloge symbole ;
- calcul à une première horloge système dans l'horloge symbole :

$$T_*(x) = T_{j-1}(x) + \nu_n \left( 1 + \left(\alpha^n + \Gamma_{1,j-1}\right)x + \left(\alpha^{2n} + \alpha^n \Gamma_{1,j-1} + \Gamma_{2,j-1}\right)x^2 + ... \right.$$
$$\left. + \sum_{i=0}^{M-1} \alpha^{in} \Gamma_{M-1-i,j-1} x^{M-1} \right) \qquad ;$$

- détermination si $\nu_n$ est un effacement ;
- Si oui : calcul à une seconde horloge système dans l'horloge symbole :

$$T_j(x) = T_*(x)\left(1 - \alpha^n x\right)$$
$$\Gamma_j(x) = \Gamma_{j-1}(x)\left(1 - \alpha^n x\right)$$

- si non : utilisation de

$$T_j(x) = T_*(x)$$
$$\Gamma_j(x) = \Gamma_*(x)$$

**7.** Le procédé de l'une quelconque des revendications précédentes 1 à 5, le calcul du polynôme syndrome modifié $T(x)$ mettant en jeu, dans les cas où un symbole entrant est signalé comme un effacement par un indicateur, une étape de mise à jour à la volée sous la forme :

$$T_n(x) = T_{n-1}(x)\left(1 - \alpha^n x\right) + \nu_n \Gamma_{n-1}(x), \text{ avec } \Gamma_{-1}(x) = 1.$$

8. Le procédé de l'une quelconque des revendications précédentes 1 à 5 ou 7, le polynôme syndrome modifié étant calculé à la volée par les étapes de :

- pré-charge des polynômes $\Gamma_{-1}(x)= 1; T_{-1}(x)= 0$,
- obtention d'un symbole $v_n$ à chaque horloge symbole,
- détermination si $v_n$ est un effacement,
- si oui : Calcul de

$$T_j(x) = T_{j-1}(x)(1 - \alpha^n x) + v_n \Gamma_{j-1}(x)$$

$$\Gamma_j(x) = \Gamma_{j-1}(x)(1 - \alpha^n x) \ ;$$

- si non : calcul de

$$T_j(x) = T_{j-1}(x) + v_n \left( 1 + (\alpha^n + \Gamma_{1,j-1})x + (\alpha^{2n} + \alpha^n \Gamma_{1,j-1} + \Gamma_{2,j-1})x^2 + \ldots \right.$$
$$\left. + \sum_{i=0}^{M-1} \alpha^{ni} \Gamma_{M-1-i,j-1} x^{M-1} \right)$$

$$\Gamma_j(x) = \Gamma_{j-1}(x) \ .$$

9. Un produit contenant un programme informatique, tel qu'un support de stockage numérique, comprenant un moyen de programme pour le décodage à décision souple de mots de code de Reed-Solomon, le moyen de programme étant adapté au calcul d'un polynôme syndrome, d'un polynôme d'effacement et d'un polynôme syndrome modifié en parallèle, en mettant à jour itérativement les coefficients desdits polynômes à chaque horloge symbole lorsqu'un nouveau symbole de données arrive, de sorte que les polynômes pour un mot de code soient obtenus directement après que la mise à jour des coefficients pour le dernier symbole du mot de code a été effectuée,

10. Un décodeur de mots de code de Reed-Solomon comprenant un moyen de calcul d'un polynôme syndrome, d'un polynôme d'effacement et d'un polynôme syndrome modifié en parallèle, en mettant jour itérativement les coefficients desdits polynômes à chaque horloge symbole lorsqu'un nouveau symbole de données arrive, de sorte que les polynômes pour un mot de code soient obtenus directement après que la mise à jour des coefficients pour le dernier symbole du mot de code a été effectuée.

Fig. 1

Fig. 2

| Preload polynomials: $\Gamma_{-1}(x) = 1; T_{-1}(x) = 0$ |
|---|

| Getting one symbol $v_n$ at each symbol clock $j$ |
|---|

Compute at first system clock:

$$T_{\ast}(x) = T_{j-1}(x) + v_n\left(1 + \left(\alpha^n + \Gamma_{1,j-1}\right)x + \left(\alpha^{2n} + \alpha^n\Gamma_{1,j-1} + \Gamma_{2,j-1}\right)x^2 + \ldots + \sum_{i=0}^{M-1}\alpha^{ni}\Gamma_{M-1-i,j-1}x^{M-1}\right) \quad (20)$$

$$\Gamma_{\ast}(x) = \Gamma_{j-1}(x)$$

| Is $v_n$ an erasure? |
|---|

Yes                    No

| Compute at second system clock: | No computation at second system clock is needed: |
|---|---|
| $T_j(x) = T_{\ast}(x)\left(1 - \alpha^n x\right)$ <br> $\Gamma_j(x) = \Gamma_{\ast}(x)\left(1 - \alpha^n x\right)$     (21) | $T_j(x) = T_{\ast}(x)$ <br> $\Gamma_j(x) = \Gamma_{\ast}(x)$ |

**Fig. 3**

Fig. 4

symbol clock

symbol stream

$v_{181}=\alpha^6$  $v_{180}=\alpha^9$  $v_{179}=\alpha^{10}$  $v_{178}=\alpha^{12}$  $v_{177}=\alpha^{15}$  $v_{176}=...$  $v_0=\alpha^x$

erasure signal

system clock

1  1  2  1  1  2  1  1  1

modified syndromes

$T_{-1}(x)=0$  $T_0(x)$  $T_*(x)$  $T_1(x)$  $T_2(x)$  $T_*(x)$  $T_3(x)$  $T_4(x)$  $T_{180}(x)$

erasure polynomial

$\Gamma_0(x)=1$  $\Gamma_1(x)$  $=$  $\Gamma_2(x)$  $\Gamma_3(x)=$  $\Gamma_4(x)$  $\Gamma_{180}(x)$

Fig. 5

| Preload polynomials: $\Gamma_{-1}(x) = 1; T_{-1}(x) = 0$ |
|---|
| Getting one symbol $v_n$ at each symbol clock |

Is $v_n$ an erasure?

| yes | No |
|---|---|
| Compute:<br><br>$T_j(x) = T_{j-1}(x)(1 - \alpha^n x) + v_n \Gamma_{j-1}(x)$<br><br>$\Gamma_j(x) = \Gamma_{j-1}(x)(1 - \alpha^n x)$<br><br>(46) | $T_j(x) = T_{j-1}(x) + v_n\left(1 + \left(\alpha^n + \Gamma_{1,j-1}\right)x + \left(\alpha^{2n} + \alpha^n\Gamma_{1,j-1} + \Gamma_{2,j-1}\right)x^2 + \dots\right.$<br><br>Compute: $\left. + \sum_{i=0}^{M-1} \alpha^{ni}\Gamma_{M-1-i,j-1}x^{M-1}\right)$<br><br>$\Gamma_j(x) = \Gamma_{j-1}(x)$<br><br>(47) |

**Fig. 6**

**Fig. 7**

switches are toggled if $v_n$ is an erasure

**symbol clock = system clock**

**symbol stream**

$v_{181}=\alpha^6$ | $v_{180}=\alpha^9$ | $v_{179}=\alpha^{10}$ | $v_{178}=\alpha^{12}$ | $v_{177}=\alpha^{15}$ | $v_{176}=...$ | $v_0=\alpha^x$

**erasure signal**

1    1    1    1    1    1

**modified syndromes**

$T_{-1}(x)=0$ | $T_0(x)$ | $T_1(x)$ | $T_2(x)$ | $T_3(x)$ | $T_4(x)$ | $T_{180}(x)$

**erasure polynomial**

$\Gamma_{-1}(x)=1=$ | $\Gamma_0(x)$ | $\Gamma_1(x)$ = $\Gamma_2(x)$ | $\Gamma_3(x)$ = $\Gamma_4(x)$ | $\Gamma_{180}(x)$

**Fig. 8**